# EUROPEAN PATENT APPLICATION

(11) **EP 4 756 865 A1**
(43) Date of publication of application: **10.06.2026**
(21) Application number: 25165722.7
(22) Date of filing: 24.03.2025
(51) Int. Cl.: H01L 21/20

(54) **SEMICONDUCTOR STRUCTURE AND FABRICATING METHOD THEREOF**

(30) Priority: 06.12.2024 TW 113147366
(71) Applicant: Hon Hai Precision Industry Co., Ltd., 236038 New Taipei City (TW)
(72) Inventor: SHEN, Chih-Yen, 300093 Hsinchu City (TW)
(74) Representative: Winter, Brandl - Partnerschaft mbB

(57) **Abstract**

A semiconductor structure includes a substrate, a first group III nitride structure, and a second group III nitride structure. The first group III nitride structure is disposed on the substrate, in which an upper surface of the first group III nitride structure has a plurality of pentagonal pits. The second group III nitride structure is disposed on the first group III nitride structure and fills the pentagonal pits. A method of fabricating the semiconductor structure includes the following operations. A first group III nitride structure is formed on the substrate. A carbon layer is deposited on the first group III nitride structure. The carbon layer and the first group III nitride structure are etched to form a plurality of pits. The second group III nitride structure is formed on the first group III nitride structure and fills the pits.

## Description

### BACKGROUND

### Field of Invention

The present disclosure relates to a semiconductor structure and a fabricating method of the semiconductor structure.

### Description of Related Art

Generally speaking, during a semiconductor structure process of growing a group III nitride layer on a substrate, the semiconductor structure is prone to bending and/or cracking due to differences in lattice constants and thermal expansion coefficients between the substrate and the group III nitride layer. Therefore, there is an urgent need to develop a semiconductor structure to improve the above problems.

### SUMMARY

The present disclosure provides a semiconductor structure, and the semiconductor structure includes a substrate, a first group III nitride structure disposed on the substrate, and a second group III nitride structure. An upper surface of the first group III nitride structure has a plurality of pentagonal pits. The second group III nitride structure is disposed on the first group III nitride structure and to fill the pentagonal pits.

The present disclosure provides a method of fabricating a semiconductor structure, and the method includes the following operations. A first group III nitride structure is formed on the substrate. A carbon layer is deposited on the first group III nitride structure. The carbon layer and the first group III nitride structure are etched to form a plurality of pits. The second group III nitride structure is formed on the first group III nitride structure and to fill the pits.

### BRIEF DESCRIPTION OF THE DRAWINGS

Fig. 1 is a flow diagram of a method of fabricating a semiconductor structure, in accordance with some embodiments of the present disclosure.
Figs. 2-3 are cross-sectional views illustrating intermediate stages of fabricating the semiconductor structure, in accordance with some embodiments of the present disclosure.
Fig. 4 is an enlarge image of a section A in Fig. 3.
Figs. 5-7 are cross-sectional views illustrating intermediate stages of fabricating the semiconductor structure, in accordance with some embodiments of the present disclosure.

### DETAILED DESCRIPTION

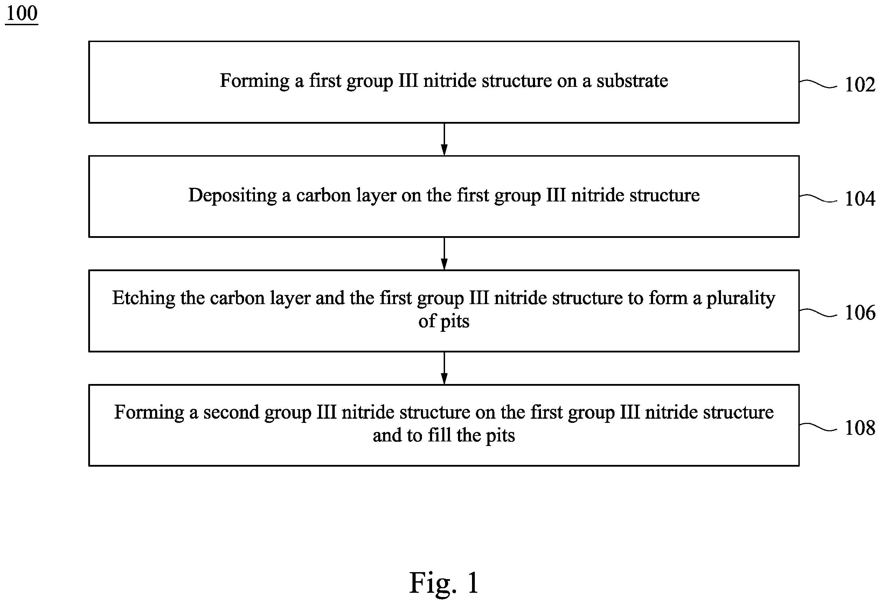

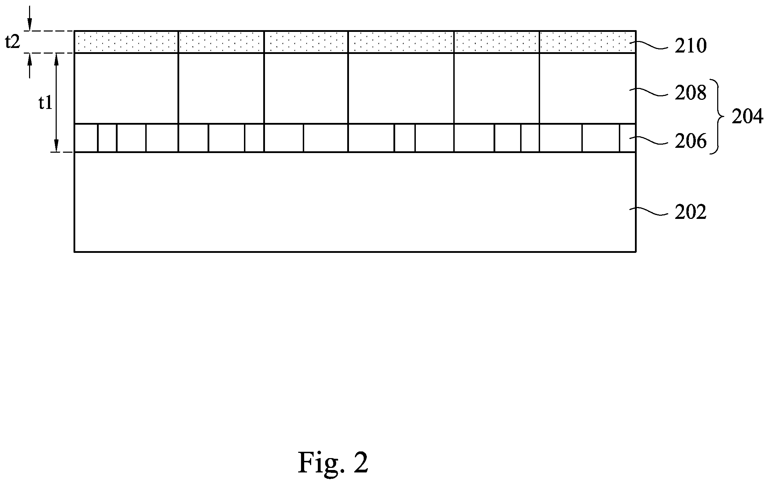

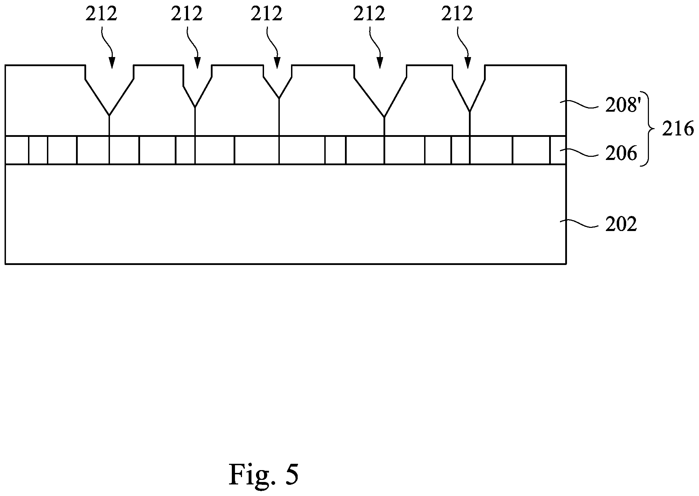

Fig. 1 is a flow diagram of a method 100 of fabricating a semiconductor structure, in accordance with some embodiments of the present disclosure. The method 100 includes operations 102, 104, 106, and 108. Figs. 2, 3, and 5-7 are cross-sectional views illustrating intermediate stages of fabricating the semiconductor structure 200A/200B, in accordance with some embodiments of the present disclosure. Refer to Figs. 1 and 2. In operation 102, a first group III nitride structure 204 is formed on a substrate 202. In some embodiments, the substrate 202 includes Si, SiC, sapphire, MgO, GaN, ZnO, AIN, Ga₂O₃, Al₂O₃, or combinations thereof, in which Si is, for example Si having a (111) crystal plane. In some embodiments, the first group III nitride structure 204 includes a single group III nitride layer or multiple group III nitride layers. In some embodiments, the first group III nitride structure 204 includes AlGaN, AlN, GaN, InAlN, InGaN, or combinations thereof. As shown in Fig. 2, in some embodiments, the first group III nitride structure 204 includes a nucleation layer 206 and a first group III nitride layer 208 on the nucleation layer 206, in which the nucleation layer 206 includes AIN, InAlN, SiC, or combinations thereof, and the first group III nitride layer 208 includes AIN, AlGaN, GaN, InGaN, InAlN, or combinations thereof. In some embodiments, the first group III nitride layer 208 includes Al_{X}Ga_{1-X}N, in which X is 0.15 to 1, such as 0.15, 0.2, 0.25, 0.3, 0.35, 0.4, 0.45, 0.5, 0.55, 0.6, 0.65, 0.7, 0.75, 0.8, 0.85, 0.9, 0.95, or 1. In some embodiments, the first group III nitride structure 204 merely includes the nucleation layer 206. In some embodiments, forming the first group III nitride structure 204 on the substrate 202 is performed by an epitaxy method such as metal-organic chemical vapor deposition (MOCVD), hydride vapor phase epitaxy (HVPE), molecular beam epitaxy (MBE), sputtering, ionic electroplating, or other suitable epitaxy methods. In some embodiments, a thickness t1 of the first group III nitride structure 204 is 100 nm to 4000 nm, such as 100, 250, 500, 750, 1000, 1250, 1500, 1750, 2000, 2250, 2500, 2750, 3000, 3250, 3500, 3750, or 4000 nm. When the thickness t1 of the first group III nitride structure 204 is 100 nm to 4000 nm, it can prevent the first group III nitride structure 204 and an epitaxial layer formed on the first group III nitride structure 204 from breaking or prevent the substrate 202 from cracking. For example, it can prevent the following situations. When the epitaxial layer formed on the first group III nitride structure 204 uses a material including Ga during the epitaxial growth on the first group III nitride structure 204, Ga can be easily diffused to the surface of the substrate 202, for example, Si substrate, such that Ga and Si of the substrate 202 forms a molten state. Thus, the first group III nitride structure 204 and the epitaxial growth formed on the first group III nitride structure 204 breaks or the substrate 202 cracks.

Refer to Figs. 1 and 2. In operation 104, a carbon layer 210 is deposited on the first group III nitride structure 204. In some embodiments, if the first group III nitride structure 204 merely includes the nucleation layer 206, the carbon layer 210 directly contacts the nucleation layer 206. In some embodiments, the carbon layer 210 is deposited by the deposition process such as the metal-organic chemical vapor deposition process, the chemical vapor deposition process, the physical vapor deposition process, the atomic layer deposition process, or other suitable deposition process. In some embodiments, depositing the carbon layer 210 on the first group III nitride structure 204 is depositing the carbon layer 210 by methane gas, ethane gas, propane gas, hexane gas, acetylene gas, ethylene gas, propylene gas, butane gas, butene gas, cyclopentane, cyclopentene, hexene, N(CH₃)₃, or combinations thereof. In some embodiments, the carbon layer 210 includes polycrystalline carbon, amorphous carbon, or a combination thereof, in which polycrystalline carbon includes graphite, and amorphous carbon includes hard carbon, soft carbon, or a combination thereof. In some embodiments, a thickness t2 of the carbon layer 210 is 5 nm to 30 nm, such as 5, 10, 15, 20, 25, or 30 nm.

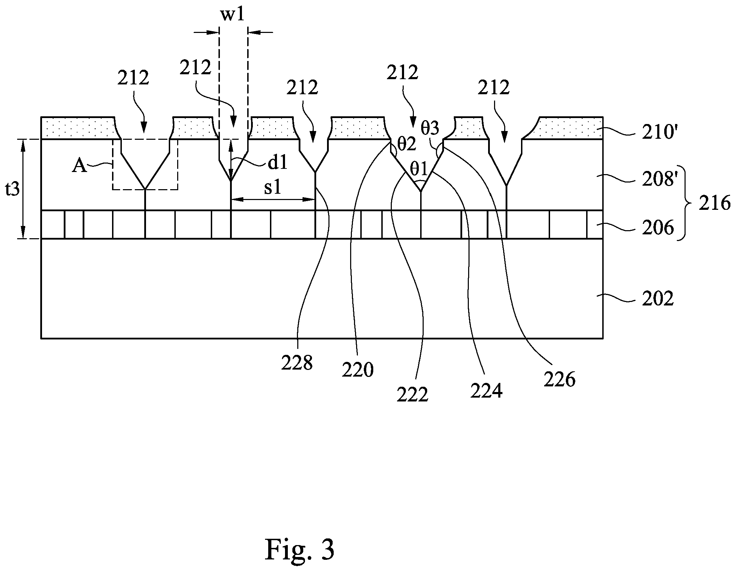

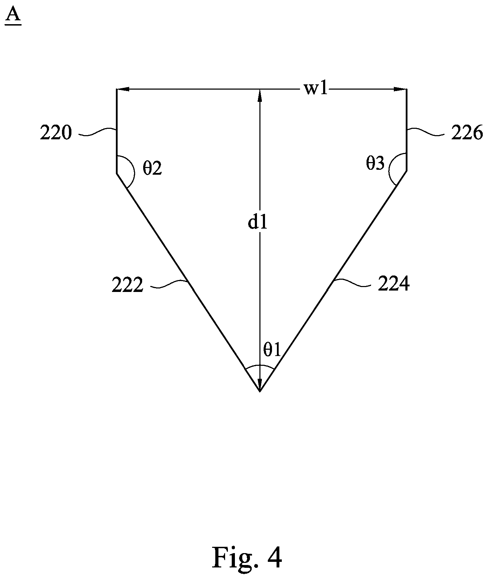

Refer to Figs. 1 to 3. In operation 106, the carbon layer 210 and the first group III nitride structure 204 are etched to form a plurality of pits 212, a carbon layer 210', and a first group III nitride structure 216. In some embodiments, the first group III nitride structure 216 includes the nucleation layer 206 and a first group III nitride layer 208'. In some embodiments, etching the first group III nitride structure 204 includes etching the first group III nitride layer 208 to form the first group III nitride layer 208'. In some embodiments, if the first group III nitride structure 204 merely includes the nucleation layer 206, etching the first group III nitride structure 204 includes etching the nucleation layer 206. Refer to the pits 212 for the pits formed by etching the nucleation layer 206. In some embodiments, etching the carbon layer 210 and the first group III nitride structure 204 include in-situ etching the carbon layer 210 and the first group III nitride structure 204. In some embodiments, etching the carbon layer 210 and the first group III nitride structure 204 to form the pits 212 is performed by chlorine gas and nitrogen gas. For example, it is performed by chlorine plasma and nitrogen plasma at the same time or by the pyrolysis of chlorine gas and nitrogen gas to form chlorine-based related etching reaction precursor. In some embodiments, before and after etching the carbon layer 210 and the first group III nitride structure 204, the thickness of the first group III nitride structure remains unchanged (the thickness t1 equals to a thickness t3). In some embodiments, top views of the pits 212 are hexagons. Fig. 4 is an enlarge image of a section A in Fig. 3. Refer to Fig. 4. In some embodiments, cross-sections of the pits 212 are in shapes of inverted pentagon. In some embodiments, the pits 212 have a first sidewall 220, a second sidewall 222, a third sidewall 224, and a fourth sidewall 226 in a cross-section, the second sidewall 222 is intersected with the first sidewall 220 and the third sidewall 224, the third sidewall 224 is intersected with the second sidewall 222 and the fourth sidewall 226, and an included angle 81 of the second sidewall 222 and the third sidewall 224 is 20 degrees to 120 degrees, such as 20, 30, 40, 50, 60, 70, 80, 90, 100, 110, or 120 degrees. If the included angle θ1 of the second sidewall 222 and the third sidewall 224 is 20 degrees to 120 degrees, the extension of dislocations 228 into layers and structures on the first group III nitride structure 216 (for example, a second group III nitride structure) can be reduced or terminated. In some embodiments, an included angle θ2 of the first sidewall 220 and the second sidewall 222 and an included angle θ3 of the third sidewall 224 and the fourth sidewall 226 are less than 180 degrees, such as 10, 20, 30, 40, 50, 60, 70, 80, 90, 100, 110, 120, 130, 140, 150, 160, 170, or 180 degrees. In some embodiments, the included angles θ2, θ3 are respectively 90 degrees to 150 degrees. When the included angle θ2 of the first sidewall 220 and the second sidewall 222 and the included angle θ3 of the third sidewall 224 and the fourth sidewall 226 are respectively 90 degrees to 150 degrees, the extension of the dislocations 228 into layers and structures on the first group III nitride structure 216 (for example, a second group III nitride structure) can be reduced or terminated. In some embodiments, opening widths w1 of the pits 212 are 20 nm to 500 nm, such as 20, 50, 100, 150, 200, 250, 300, 350, 400, 450, or 500 nm. In some embodiments, the thickness t2 of the carbon layer 210 and the etching temperature of the carbon layer 210 and the first group III nitride structure 204 may affect the etching rate of the carbon layer 210 and the first group III nitride structure 204, and further affect the opening widths w1 and the included angles θ1, θ2, θ3 of the pits 212. In some embodiments, the pits 212 have an aspect ratio of 0.5 to 4, such as 0.5, 1, 1.5, 2, 2.5, 3, 3.5, or 4, and the aspect ratio of the pits 212 is a value calculated by dividing a depth d1 of the pits 212 by an opening width w1 of the pits 212. Refer to Fig. 3. In some embodiments, the pits 212 are formed on the dislocations 228 of the first group III nitride structure 216. In some embodiments, when spacings s1 between the adjacent dislocations 228 are less than or equal to 200 nm (for example, 10, 20, 40, 60, 80, 100, 120, 140, 160, 180, or 200 nm), the aspect ratio of the pits 212 is 0.5 to 2 (for example, 0.5, 0.6, 0.8, 1, 1.2, 1.4, 1.6, 1.8, or 2). In some embodiments, when spacings s1 between the adjacent dislocations 228 are greater than 200 nm, preferably 200 nm to 500 nm (for example, 200, 225, 250, 275, 300, 325, 350, 375, 400, 425, 450, 475, or 500 nm), the aspect ratio of the pits 212 is 1.5 to 4 (for example, 1.5, 2, 2.5, 3, 3.5, or 4). Since the carbon layer 210 has a high corrosion resistance to etching gases, for example, hydrogen gas, chlorine gas, hydrogen chloride gas, or other suitable gases (that is, etching the carbon layer 210 with the aforementioned etching gases has an extremely low etching rate), depositing the carbon layer 210 on the first group III nitride structure 204 can be served as a protection layer of the first group III nitride structure 204. Thus, during etching the carbon layer 210 and the first group III nitride structure 204, the thickness of the first group III nitride structure remains unchanged (the thickness t1 equals to the thickness t3), thereby forming the pits 212 with high aspect ratio. Forming the pits 212 with high aspect ratio may greatly reduce the hardness of the subsequent epitaxial process, may prevent the dislocation defects extend to structures or layers on the first group III nitride structure 216 (for example, second group III nitride structure), may improve the termination ability of the dislocations 228, and may easily acquire a flat surface for structures and layers formed on the first group III nitride structure 216 subsequently, for example, second group III nitride structure (the epitaxial growth of the thinner second group III nitride structure may still obtain a flat surface), such that the quality and the yield of the semiconductor structure are improved. Refer to the thickness t2 of the carbon layer 210 for a thickness of the carbon layer 210'.

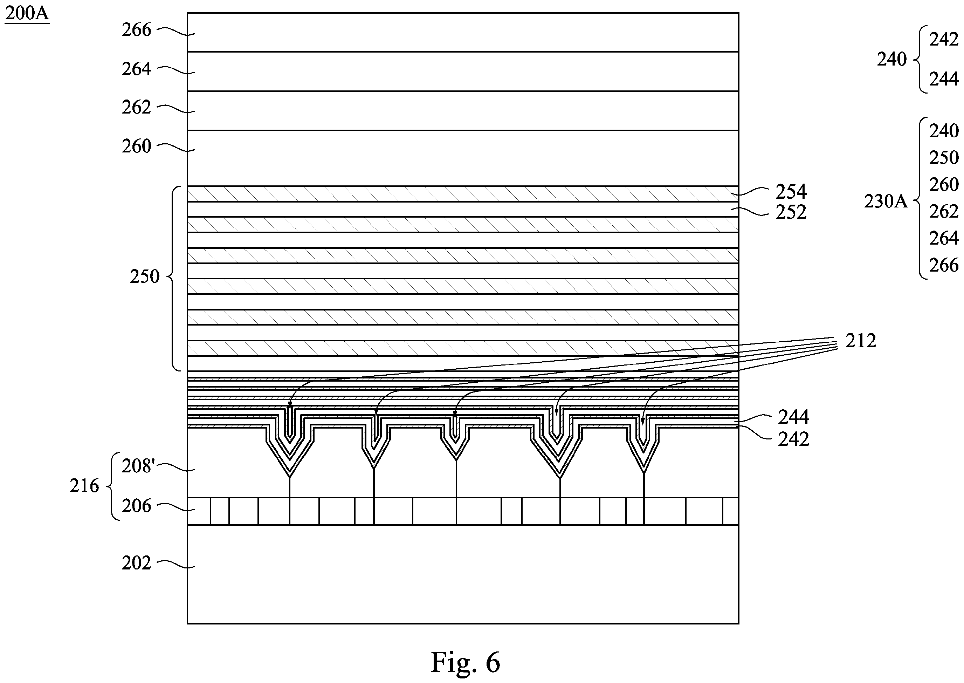

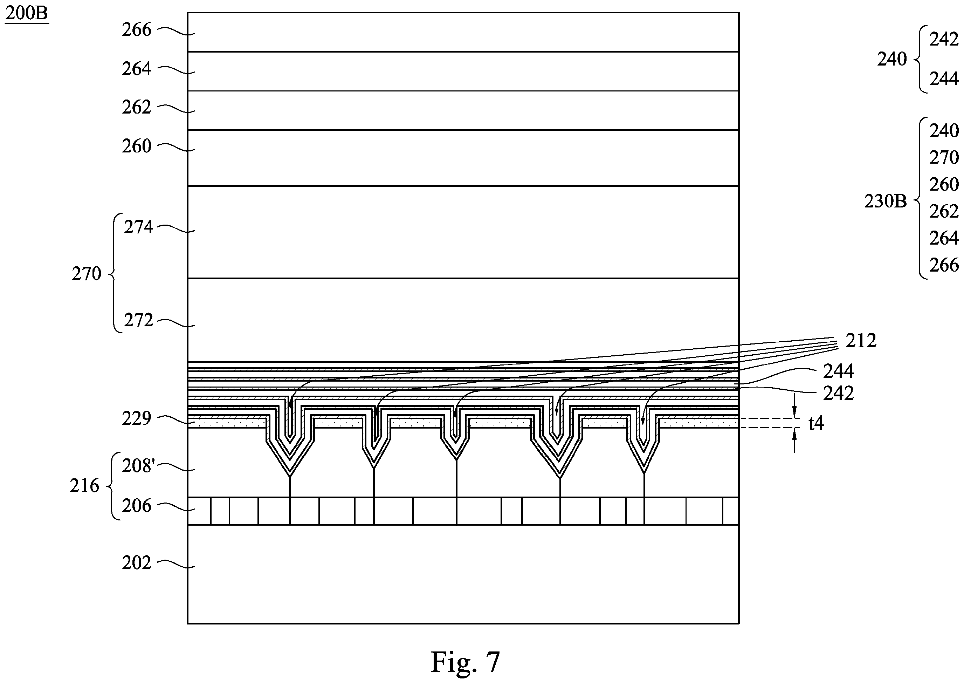

Refer to Figs. 1-3 and 5. In some embodiments, the method 100 further includes after etching the carbon layer 210 and the first group III nitride structure 204 to form the pits 212, the carbon layer 210', and the first group III nitride structure 216 (operation 106), removing the carbon layer 210'. In some embodiments, removing the carbon layer 210' includes in-situ etching the carbon layer 210'. In some embodiments, the carbon layer 210' is removed by the dry etching process, for example, removing the carbon layer 210' is performed by nitrogen gas and ammonia gas. For example, it is performed by using nitrogen plasma and ammonia plasma or nitrogen gas and ammonia gas via pyrolysis to provide NH-based and/or NH₂-based related etching reaction precursors. When removing the carbon layer 210' is performed by nitrogen gas and ammonia gas, nitrogen gas and ammonia gas are reacted with the carbon layer 210' to form HCN gas to etch the carbon layer 210'. At the same time, the dislocation defects on the upper surface of the first group III nitride structure 216 are also repaired. In some embodiments, removing the carbon layer 210' includes completely removing the carbon layer 210' (refer to Fig. 6) or partially removing the carbon layer 210' to form a carbon layer 229 (refer to Fig. 7). In some embodiments, take the thickness of the carbon layer 210' as an example of 30 nm, the partial removal of the carbon layer 210' is to remove the carbon layer 210' between 20 nm and 29 nm, such as 20, 21, 22, 23, 24, 25, 26, 27, 28, or 29 nm. That is, a thickness t4 of the remaining carbon layer 229 is 1 nm to 10 nm, such as 1, 2, 3, 4, 5, 6, 7, 8, 9, or 10 nm, as shown in Fig. 7. When the thickness t4 of the carbon layer 229 is greater than or equal to 5 nm, a surface of the carbon layer 229 is substantially flat. When the thickness t4 of the carbon layer 229 is less than or equal to 3 nm, the surface of the carbon layer 229 forms partially island-like or rugged distribution. The thinner the thickness t4 of the carbon layer 229, the more the contact area proportion between the first group III nitride layer 208' and the layers formed subsequently on the first group III nitride layer 208'. When the carbon layer 210' is removed by nitrogen gas and ammonia gas, the remaining carbon layer 229 can serve as an epitaxial blocking layer, such that the structures or the layers formed on the first group III nitride structure 216 subsequently (for example, the second group III nitride structure) may reduce the dislocation density, thereby enhancing the quality and the yield of the semiconductor structure.

Refer to Figs. 1 and 6. In operation 108, a second group III nitride structure 230A is formed on the first group III nitride structure 216 and to fill the pits 212. In some embodiments, if the first group III nitride structure 216 merely includes the nucleation layer 206, the second group III nitride structure 230A may directly contact the nucleation layer 206. In some embodiments, a thickness of the second group III nitride structure 230A is 820 nm to 7250 nm, such as 820, 1000, 2000, 3000, 4000, 5000, 6000, 7000, or 7250 nm. The thinner the thickness of the first group III nitride structure 216, the thicker the thickness of second group III nitride structure 230A. On the contrary, the thicker the thickness of the first group III nitride structure 216, the thinner the thickness of second group III nitride structure 230A. When the thickness of the second group III nitride structure 230A is 820 nm to 7250 nm, the stress control capability of the semiconductor structure may be enhanced, thereby improving the quality and the yield of the semiconductor structure. In some embodiments, the second group III nitride structure 230A is formed by, for example, MOCVD, HVPE, MBE, sputtering, ionic electroplating, or other suitable epitaxy methods. When the second group III nitride structure 230A is formed on the first group III nitride structure 216 and to fill the pits 212, the dislocation density of the second group III nitride structure 230A decreases and the stress control capability of the semiconductor structure is strengthened, thereby improving the quality and the yield of the semiconductor structure. In some embodiments, the dislocation density of the second group III nitride structure 230A is 5×10⁷ cm⁻² to 8×10⁸ cm⁻², such as 5×10⁷, 7×10⁷, 9×10⁷, 2×10⁸, 4×10⁸, 5×10⁸, 6×10⁸, or 8×10⁸ cm⁻². The dislocation density of the second group III nitride structure 230A can be measured by the following methods. It can measure by transmission electron microscope (TEM) cross section analysis. It can measured by wet chemical etching (for example, molten potassium hydroxide), and then calculate the quantity of the pits by scanning electron microscope (SEM) top view. It can measure by high resolution atomic force microscope (AFM) analysis, and then calculate the dislocation density of small holes on the sample surface. Applied to the semiconductor epitaxial structure of the present disclosure, when the dislocation density of the second group III nitride structure 230A (device operation area) is less than 5×10⁸ cm⁻², the leakage behavior of the semiconductor device on the wafer may be greatly improved, thereby obtaining a better overall yield. In some embodiments, there are voids in the second group III nitride structure 230A. When voids are in the second group III nitride structure 230A, the stress of the semiconductor structure may be released, thereby improving the quality and the yield of the semiconductor structure. In some embodiments, the second group III nitride structure 230A includes multiple group III nitride layers, in which multiple group III nitride layers can be replaced by a single group III nitride layer. In some embodiments, the second group III nitride structure 230A includes AIN, AlGaN, GaN, InGaN, InAlN, or combinations thereof. In some embodiments, the second group III nitride structure 230A includes one or more superlattice structure(s). In some embodiments, the second group III nitride structure 230A is a superlattice structure 240, a superlattice structure 250, a GaN layer 260 (a thickness of 500 nm to 1500 nm, such as 500, 750, 1000, 1250, or 1500 nm), a GaN layer 262 (a thickness of 150 nm to 600 nm, such as 150, 300, 450, or 600 nm), a AlGaN layer 264 (a thickness of 10 nm to 30 nm, such as 10, 15, 20, 25, or 30 nm), and a pGaN layer 266 (a thickness of 50 nm to 120 nm, such as 50, 70, 90, 110, or 120 nm) in order from the bottom to the top. In some embodiments, the pGaN layer 266 includes a nitride of 2A group elements such as Be, Mg, Ca, Sr, Ba, Ra, or combinations thereof and GaN, in which GaN can also be replaced by AlGaN and InAlN. In some embodiments, the thicknesses of the superlattice structures 240, 250 are respectively 1000 nm to 2500 nm, such as 1000, 1250, 1500, 1750, 2000, 2250, or 2500 nm. In some embodiments, the superlattice structure 240 includes a first superlattice layer 242 and a second superlattice layer 244 that are alternatively stacked, in which the first and second superlattice layers 242, 244 having different materials respectively include a AIN layer and a Al_{X}Ga_{1-X}N layer (X is 0.3 to 0.6, such as 0.3, 0.4, 0.5, or 0.6). In some embodiments, the superlattice structure 250 includes a first superlattice layer 252 and a second superlattice layer 254 that are alternatively stacked, in which the first and second superlattice layers 252, 254 having different materials respectively include a AIN layer and a Al_{Y}Ga_{1-Y}N layer (Y is 0.15 to 0.45, such as 0.15, 0.2, 0.25, 0.3, 0.35, 0.4, or 0.45). The first and second superlattice layers 242, 244, 252, 254 can be respectively replaced by any one of GaN layer, AIN layer, AlGaN layer, InGaN layer, or InAlN layer. When the second group III nitride structure 230A includes the superlattice structures 240 and 250, the dislocation density of the second group III nitride structure 230A decreases (the termination of the dislocation growth) and the stress control capability of the semiconductor structure is strengthened by adjusting the Al contents in the superlattice structures 240, 250. It can acquire a final wafer curvature, thereby improving the quality and the yield of the semiconductor structure.

Refer to Fig. 7. When a portion of the carbon layer 229 is retained on the first group III nitride structure 216, a second group III nitride structure 230B is formed on the first group III nitride structure 216 and the carbon layer 229 and to fill the pits 212, and the process is performed by selective epitaxy growth (SEG). In detail, when the second group III nitride structure 230B is on the first group III nitride structure 216 and the carbon layer 229 and to fill the pits 212, the second group III nitride structure 230B has a relatively fast epitaxial growth rate at the surface of the first group III nitride structure 216 uncovered by the carbon layer 229 because a surface of the carbon layer 229 can be served as a hard mask to block or slow down the epitaxial growth of the second group III nitride structure 230B. When forming the second group III nitride structure 230B on the first group III nitride structure 216 and the carbon layer 229 and to fill the pits 212 is performed by SEG, the dislocation density of the second group III nitride structure 230B decreases, thereby improving the quality and the yield of the semiconductor structure. In some embodiments, the second group III nitride structure 230B is formed by replacing the superlattice structure 250 in the second group III nitride structure 230A with a AlGaN structure 270 (having a plurality of AlGaN layers, the Al contents of the layers are gradually reduced), in which the superlattice structure 240 may also replace by the superlattice structure 250 or other superlattice structures. In some embodiments, the AlGaN structure 270 includes AlGaN layers 272, 274. In some embodiments, the AlGaN layer 272 is a Al_{X}Ga_{1-X}N layer (X is 0.4 to 0.6, such as 0.4, 0.45, 0.5, 0.55, or 0.6) with a thickness of 500 nm to 1200 nm, such as 500, 600, 700, 800, 900, 1000, 1100, or 1200 nm, and the AlGaN layer 274 is a Al_{Y}Ga_{1-Y}N layer (Y is 0.05 to 0.4, such as 0.05, 0.1, 0.15, 0.2, 0.25, 0.3, 0.35, or 0.4) with a thickness of 500 nm to 1500 nm, such as 500, 750, 1000, 1250, or 1500 nm. In some embodiments, the AlGaN structure 270 further includes an Al_{Z}Ga_{1-Z}N layer (Z is 0.6 to 0.9, such as 0.6, 0.65, 0.7, 0.75, 0.8, 0.85, or 0.9) disposed under the AlGaN layer 272. When the second group III nitride structure 230B includes the AlGaN structure 270, a turning angle of dislocations in the second group III nitride structure 230B increases in comparison with a turning angle of the dislocations 228 because the Al content of the AlGaN layers gradually decreases. Thus, the dislocation defect density in an usage area of the active components, for example, the GaN layer 262, the AlGaN layer 264, the pGaN layer 266, and in other locations decrease, thereby improving the quality and the yield of the semiconductor structure. Refer to the embodiments and effects of the second group III nitride structure 230A for other embodiments and effects of the second group III nitride structure 230B. The second group III nitride structure 230A of Fig. 6 can be replaced with the second group III nitride structure 230B of Fig. 7. Similarly, the second group III nitride structure 230B of Fig. 7 can be replaced with the second group III nitride structure 230A of Fig. 6.

Refer to Fig. 6. The semiconductor structure 200A includes the substrate 202, the first group III nitride structure 216 disposed on the substrate 202, and the second group III nitride structure 230A. An upper surface of the first group III nitride structure 216 has a plurality of pentagonal pits 212. The second group III nitride structure 230A is disposed on the first group III nitride structure 216 and to fill the pentagonal pits 212. Refer to Fig. 7. In some embodiments, the semiconductor structure 200B further includes the carbon layer 229 disposed between the first and second group III nitride structures 216, 230B. Refer to the components and the configuration relationships of the aforementioned semiconductor structure 200A for the other components and the configuration relationships of the semiconductor structure 200B. Refer to the embodiments and/or the effects in the aforementioned method 100 of fabricating the semiconductor structures 200A, 200B for the embodiments and/or the effects of the substrate 202, the first group III nitride structure 216, the carbon layer 229, the second group III nitride structures 230A, 230B, and the pentagonal pits 212.

In summary, in the semiconductor structure and the fabricating method thereof, the carbon layer is deposited on the first group III nitride structure, such that the pentagonal pits with high aspect ratios are formed during etching the carbon layer and the first group III nitride structure, thereby preventing the dislocation defects of first group III nitride structure from extending to the second group III nitride structure. Besides, the second group III nitride structure is formed on the first group III nitride structure and to fill the pits, such that the dislocation density of the second group III nitride structure decreases and the stress control capability of the semiconductor structure is enhanced. Thus, the aforementioned features may prevent the semiconductor structure from bending and/or breaking. In other words, the quality and the yield of the semiconductor structure improves.

## Claims

1. A semiconductor structure (200A, 200B), **characterized by** comprising:
a substrate (202);
a first group III nitride structure (216) disposed on the substrate (202), wherein an upper surface of the first group III nitride structure (216) has a plurality of pentagonal pits (212); and
a second group III nitride structure (230A, 230B) disposed on the first group III nitride structure (216) and to fill the pentagonal pits (212).

2. The semiconductor structure (200A, 200B) of claim 1, **characterized in that** the pentagonal pits (212) have an aspect ratio of 0.5 to 4, and the aspect ratio of the pentagonal pits (212) is a value calculated by dividing a depth (d1) of the pentagonal pits (212) by an opening width (w1) of the pentagonal pits (212).

3. The semiconductor structure (200A, 200B) of any one of claims 1 to 2, **characterized in that** the pentagonal pits (212) have a first sidewall (220), a second sidewall (222), a third sidewall (224), and a fourth sidewall (226) in a cross-section, the second sidewall (222) is intersected with the first sidewall (220) and the third sidewall (224), the third sidewall (224) is intersected with the second sidewall (222) and the fourth sidewall (226), and an included angle (θ1) of the second sidewall (222) and the third sidewall (224) is 20 degrees to 120 degrees.

4. The semiconductor structure (200A, 200B) of claim 3, **characterized in that** an included angle (θ2) of the first sidewall (220) and the second sidewall (222) and an included angle (θ3) of the third sidewall (224) and the fourth sidewall (226) are respectively less than 180 degrees.

5. The semiconductor structure (200A, 200B) of any one of claims 1 to 4, **characterized by** further comprising a carbon layer (229) disposed between the first group III nitride structure (216) and the second group III nitride structure (230A, 230B).

6. A method (100) of fabricating a semiconductor structure (200A, 200B), **characterized by** comprising:
forming a first group III nitride structure (204) on a substrate (202);
depositing a carbon layer (210) on the first group III nitride structure (204);
etching the carbon layer (210) and the first group III nitride structure (204) to form a plurality of pits (212); and
forming a second group III nitride structure (230A, 230B) on the first group III nitride structure (216) and to fill the pits (212).

7. The method (100) of claim 6, **characterized in that** when depositing the carbon layer (210) on the first group III nitride structure (204), the carbon layer (204) is deposited by methane gas, ethane gas, propane gas, hexane gas, acetylene gas, ethylene gas, propylene gas, butane gas, butene gas, cyclopentane, cyclopentene, hexene, N(CH₃)₃, or combinations thereof.

8. The method (100) of any one of claims 6 to 7, **characterized in that** etching the carbon layer (210) and the first group III nitride structure (204) to form the pits (212) is performed by chlorine gas and nitrogen gas.

9. The method (100) of any one of claims 6 to 8, **characterized by** further comprising:
after etching the carbon layer (210) and the first group III nitride structure (204) to form the pits (212), removing the carbon layer (210').

10. The method (100) of claim 9, **characterized in that** removing the carbon layer (210') is performed by nitrogen gas and ammonia gas.
